Europäisches Patentamt

European Patent Office

Office européen des brevets

(19)

(11) Numéro de publication : **0 149 408**
**B1**

(12) FASCICULE DE BREVET EUROPÉEN

(45) Date de publication du fascicule du brevet :
27.07.88

(51) Int. Cl.⁴ : **C 23 C 16/50// C23C14/34**

(21) Numéro de dépôt : **84420217.6**

(22) Date de dépôt : **21.12.84**

(54) Procédé et dispositif pour le dépôt, sur un support, d'une couche mince d'un matériau à partir d'un plasma réactif.

(30) Priorité : **27.12.83 FR 8321047**

(43) Date de publication de la demande :
**24.07.85 Bulletin 85/30**

(45) Mention de la délivrance du brevet :
**27.07.88 Bulletin 88/30**

(84) Etats contractants désignés :
**DE GB**

(56) Documents cités :
**EP-A- 0 064 760**
**DD-A- 151 010**
**FR-A- 2 518 122**
**US-A- 4 285 762**
**PATENTS ABSTRACTS OF JAPAN, vol. 7, no. 111 (E-175)[1256], 14 mai 1983**
**SOLID STATE ELECTRONICS, vol. 11, no. 7, juillet 1968, pages 683-684, Pergamon Press, GB; S. VEPREK et al.: "The preparation of thin layers of Ge and Si by chemical hydrogen plasma transport"**
**ZEITSCHRIFT FÜR NATURFORSCHUNG A, vol. 29A, no. 12, 1969, pages 2025-2026; S. VEPREK et al.: "Darstellung von Aluminiumnitrid durch Umsetzung von Aluminium in einem nicht-isothermen Sticks-toff/Chlor-Niederdruckplasma"**
**PATENTS ABSTRACTS OF JAPAN, vol. 4, no. 50 (C-7)[532], 1980, page 36 C 7**

(73) Titulaire : **ETAT FRANCAIS représenté par le Ministre des PTT (Centre National d'Etudes des Télécommunications)**
**38-40 rue du Général Leclerc**
**F-92131 Issy-les-Moulineaux (FR)**

**Etablissement Public dit: CENTRE NATIONAL DE LA RECHERCHE SCIENTIFIQUE (CNRS)**
**15, Quai Anatole France**
**F-75007 Paris (FR)**

(72) Inventeur : **Pelletier, Jacques**
**"Le Murier"**
**F-38400 St. Martin d'Hères (FR)**
Inventeur : **Arnal, Yves**
**24, Avenue de la République**
**F-38320 Eybens (FR)**
Inventeur : **Pauleau, Yves**
**15, rue de Stalingrad**
**F-38100 Grenoble (FR)**

(74) Mandataire : **Ropital-Bonvarlet, Claude et al**
**Cabinet BEAU DE LOMENIE 99, Grande rue de la Guillotière**
**F-69007 Lyon (FR)**

## Description

La présente invention concerne le domaine technique du dépôt sur au moins un substrat ou support, conducteur ou non, d'une couche mince d'un métal, métalloïde ou composé.

L'invention vise, plus particulièrement, le dépôt en couche mince de matériaux sur des supports utilisés dans le domaine de la micro-électronique.

Il doit, toutefois, être considéré que l'objet de l'invention peut également s'appliquer dans tous les cas où un substrat doit être revêtu d'un matériau en couche mince pour posséder, au moins en partie et en surface, les caractéristiques physico-chimiques du matériau d'apport.

Pour revêtir un substrat d'une couche mince d'un métal ou métalloïde, l'art antérieur disponible offre deux méthodes différentes.

La première méthode est dite physique et comprend l'évaporation sous vide, le dépôt ionique et la technique de pulvérisation cathodique.

Les inconvénients pouvant être portés au compte d'une telle méthode sont, principalement, le manque d'homogénéité sur de grandes surfaces et la difficulté d'obtenir des composés parfaitement stœchiométriques.

La seconde méthode est dite chimique et fait intervenir les procédés de dépôt par réaction chimique en phase gazeuse, par transport chimique, par évaporation réactive et par pulvérisation cathodique réactive.

Le procédé de dépôt par réaction chimique en phase gazeuse, pouvant être qualifié de système ouvert, consiste à introduire un ou plusieurs gaz réactifs dans un réacteur en atmosphère dynamique. Le matériau à déposer est formé par dissociation ou par combinaison des gaz réactifs.

A titre d'exemple, un film de silicium peut être déposé selon ce procédé, par dissociation thermique du silane ($SiH_4$). Un film de carbure de hafnium (HfC) peut être préparé par action du méthane ($CH_4$) sur le chlorure métallique de hafnium ($HfCL_2$). Selon ce procédé, un des gaz réactifs peut être préparé in situ.

Les réactions chimiques, intervenant sans activation du milieu réactionnel, ont lieu à des températures relativement élevées.

Or, dans de nombreuses applications, telles que la micro-électronique, pour lesquelles la fabrication des circuits intégrés à haute densité d'intégration doit éviter impérativement la déformation des substrats, la diffusion d'impuretés et/ou des dopants introduits dans les substrats et la création de défauts structuraux, ces températures sont trop élevées.

Le procédé de dépôt par transport chimique permet de faire croître des cristaux et d'obtenir des couches minces de matériaux polycristallins, en plaçant le matériau devant être déposé et le substrat à revêtir aux deux extrémités d'un tube scellé contenant une certaine pression d'un gaz vecteur, par exemple de l'iode. Les deux extrémités du tube scellé sont maintenues à des températures différentes, de manière que le matériau à déposer réagisse avec le gaz vecteur pour donner un produit volatil venant se décomposer sur le substrat. Un tel processus peut se poursuivre jusqu'à épuisement du matériau à déposer.

Un des inconvénients de ce procédé, qui peut être qualifié de système à fonctionnement fermé, réside dans le risque de contamination du film de matériau déposé par les impuretés provenant de l'attaque du tube scellé porté à haute température.

La technique antérieure peut, dans ce sens, être illustrée par la publication Patent Abstracts of Japan, vol. 7, n° 111, 14 mai 1983 montrant un dispositif pour le dépôt sur un support d'une couche mince d'un matériau à partir d'un plasma entretenu par une source micro-ondes.

La demande FR-A-2 518 122 vise un même domaine technique et prévoit, en plus de moyens techniques du type précédemment évoqué, des moyens de régulation de température du substrat et de la source ainsi que des moyens de polarisation électrique de cette dernière.

Une autre méthode encore consiste à utiliser un plasma réactif en mettant en œuvre des décharges à cathode froide. Dans un tel cas, la source fournissant le matériau à déposer représente une électrode, alors que le substrat à revêtir représente la seconde électrode. Le matériau à déposer est bombardé par le gaz réactif ionisé. Les produits de réaction volatils provenant de l'attaque du matériau à déposer se dissocient avec formation du dépôt en couches minces.

Cette méthode permet d'abaisser la température de dépôt, mais ne permet pas de contrôler et de fixer, de manière indépendante, les conditions d'attaque du matériau et de dépôt du produit de réaction, car ces conditions sont prédéterminées par les conditions de la décharge. Par ailleurs, cette méthode présente un autre inconvénient tenant aux effets d'érosion ionique sur l'une ou l'autre des électrodes, ainsi que sur les parois du réacteur, ces effets d'érosion étant dus aux tensions de décharge appliquées qui fournissent des énergies relativement élevées aux particules chargées. Par ailleurs, le milieu gazeux réactif, ionisé par décharge à cathode froide, ne fournit pas un plasma homogène et ne permet donc pas d'obtenir des dépôts homogènes de matériau sur les grandes surfaces de substrat.

A la différence des procédés connus, l'objet de l'invention est de proposer un nouveau procédé et un nouveau dispositif permettant de déposer des couches minces, à basse température, sur des substrats de grande surface.

Un autre objet de l'invention est de proposer un nouveau procédé et un nouveau dispositif qui

2

permettent, dans le cas du dépôt d'un composé simple, la maîtrise de la stœchiométrie de la couche mince déposée sur le substrat par l'ajustement propre des vitesses d'érosion du matériau à déposer et de dépôt du composé déposé sur le substrat.

Un autre avantage de l'invention est de rendre possible le dépôt en couche mince sur des substrats d'un matériau de pureté supérieure à celle de la source à partir de laquelle il est prélevé.

Pour atteindre les buts ci-dessus, le procédé selon l'invention est caractérisé en ce que :
— on confine le plasma dans l'enceinte par une enveloppe de confinement magnétique, disposée à l'intérieur de l'enceinte et constituée par une cage multipolaire,
— on associe le substrat à des moyens propres de polarisation électrique,
— et on ajuste, de façon indépendante, les polarisations électriques de la source et du substrat.

L'invention vise, également, un dispositif pour la mise en œuvre du procédé, un tel dispositif étant caractérisé en ce qu'il comprend :
— une enveloppe de confinement magnétique du plasma, disposée dans l'enceinte et constituée par une cage multipolaire,
— des moyens de polarisation électrique propre du substrat,
— et des moyens pour ajuster de façon indépendante les polarisations électriques du substrat et de la source.

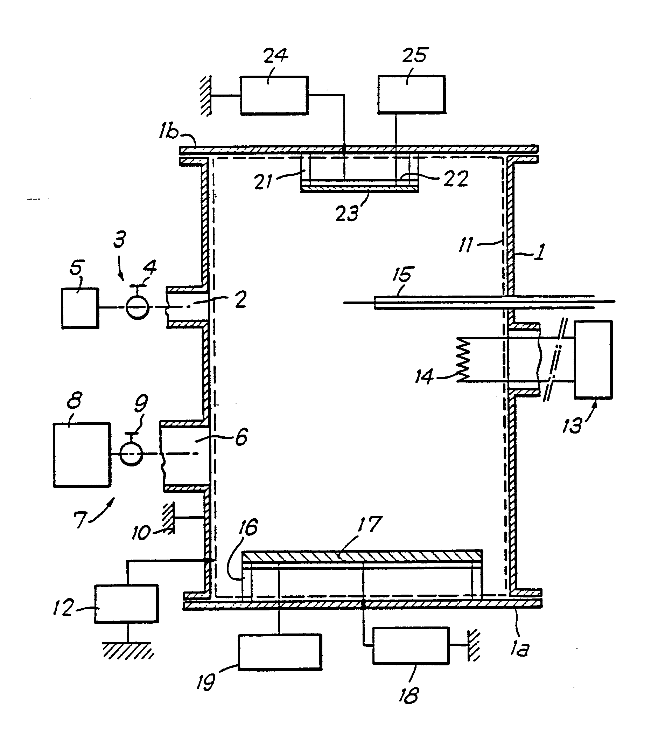

Diverses autres caractéristiques ressortent de la description faite ci-dessous en référence au dessin annexé qui montre, à titre d'exemple non limitatif, une forme de réalisation de l'objet de l'invention.

La figure unique est une coupe-élévation du dispositif de mise en œuvre de l'invention.

Le dispositif pour la mise en œuvre de l'invention comprend une enceinte 1, de préférence en un matériau amagnétique, reliée par une tubulure 2 à des moyens 3 de distribution d'un fluide gazeux approprié délivré par une vanne 4 à partir d'un réservoir de stockage 5. L'enceinte 1 est, également, reliée par une tubulure 6 à des moyens 7 de pompage comprenant une pompe 8 et une vanne 9 de réglage de débit. Pour créer un plasma à l'intérieur de l'enceinte 1, le fluide gazeux est entretenu à une pression absolue de l'ordre de quelques $10^{-5}$ à $10^{-1}$ Torr (1 Torr = 133 Pascals).

L'enceinte 1, qui est reliée à la masse 10, contient, intérieurement, une enveloppe 11 de confinement magnétique, constituée par une cage multipolaire isolée de l'enceinte 1. La cage 11 est reliée à une source 12 susceptible de la mettre en liaison avec la masse ou de la polariser.

L'enceinte 1 est associée à un générateur 13 capable de provoquer l'excitation et l'ionisation du milieu gazeux occupant l'enceinte 1. Ce générateur 13 peut comporter un filament thermo-émissif 14 ou, encore, un générateur d'ondes hyperfréquences.

L'enceinte 1 comprend, par ailleurs, une sonde de Langmuir 15 destinée à permettre l'appréciation des caractéristiques du plasma et, notamment, son potentiel.

L'enceinte 1 comporte une paroi amovible 1a supportant, par des pieds isolants 16, au moins une source 17 constituée par le matériau devant, au moins en partie, être déposé sur un substrat. La source 17 peut être constituée par une plaque ou, encore, par une coupelle dans laquelle est placé le matériau à déposer.

Quels que soient les moyens de support retenus, la source 17 est associée à des moyens 18 de polarisation propre, ainsi qu'à des moyens 19 de régulation de sa température. Ces moyens 19 peuvent comprendre un circuit de circulation d'un fluide réchauffé ou refroidi, selon qu'il convient d'apporter à ou de prélever des calories de la source 17.

L'enceinte 1 comporte une seconde paroi amovible 1b supportant, par des pieds isolants 21, un porte-substrat 22. Des moyens sont prévus sur le porte-substrat 22 pour maintenir un substrat 23 sur au moins l'une des faces exposées duquel une couche mince du matériau de la source 17 est à déposer. Le porte-substrat 22 est associé à des moyens 24 de polarisation propre et à des moyens 25 de régulation de la température du substrat 23.

Selon l'invention, le milieu gazeux, introduit dans l'enveloppe 11, est choisi du type réactif par rapport au matériau de la source 17. Ainsi, la création d'un plasma, à partir d'un tel milieu gazeux, à l'intérieur de l'enceinte 1 par les moyens propres 3, 7, 11 et 13, a pour effet de provoquer l'érosion de la source 17 et de générer un produit de réaction volatil. Ce produit est partiellement dissocié et ionisé dans le plasma confiné dans la cage multipolaire 11 et subit un transfert entre la source 17 et le substrat 23. La polarisation ainsi que la température propres du substrat 23 conduisent au dépôt, en couche mince, sur la surface exposée au plasma, du matériau issu du produit de réaction volatil.

Le procédé de l'invention est mis en œuvre en ajustant, par les moyens 18-19 et 24-25, le potentiel et la température de la source 17 et du substrat 23, de telle sorte qu'on obtienne l'érosion de la source 17 par le plasma et le dépôt sur le substrat 23.

Ainsi, les moyens de l'invention permettent de produire un plasma homogène, de grand volume, dont les paramètres de création sont totalement indépendants de ceux de son utilisation. Ceci permet d'ajuster les paramètres d'utilisation en fonction des vitesses d'érosion et de dépôt recherchées.

Il devient ainsi possible d'obtenir le dépôt en couche mince d'un matériau, de façon homogène, sur des grandes surfaces, à des températures relativement basses.

Les moyens de génération et d'utilisation propres au plasma, à la source et au substrat, permettent, également, de maîtriser, parfaitement, la stœchiométrie de la couche mince déposée. Par ailleurs, l'utilisation d'un milieu gazeux réactif, choisi en fonction de la composition de la source 17, permet de ne

prélever que certains des composés de cette source et, par suite, d'obtenir, le cas échéant, des dépôts de pureté supérieure à celle de la source, par attaque sélective, au moyen du milieu gazeux réactif choisi.

Compte tenu de la possibilité de mettre en œuvre un plasma de grand volume, il devient possible de réaliser des dépôts en couche mince sur des grandes surfaces et, le cas échéant, aussi, de déposer des couches minces sur plusieurs échantillons ou substrats simultanément.

Il est, également, possible de faire intervenir, dans l'enveloppe 11 ou enceinte 1, plus d'une source 17 susceptible d'être attaquée simultanément ou sélectivement, en modifiant la nature du milieu gazeux introduit pour générer le plasma d'attaque.

Il y a lieu de noter qu'il peut être prévu, également, de choisir le milieu gazeux réactif, de manière, éventuellement, à apporter un composé au moins entrant dans la composition de la couche mince déposée sur au moins un substrat 23.

A titre d'exemple, les paramètres suivants peuvent être retenus, pour le dépôt sur un substrat en verre d'une couche mince de silicium, à partir d'une source 17 en silicium, au moyen d'un plasma réactif d'hydrogène.

— Pression absolue d'hydrogène                                         $10^{-4}$ à $10^{-3}$ Torr
— Densité du plasma                                        $3 \times 10^{11}$ ions/cm$^3$
— Polarisation de la source comprise entre           — 10 et — 100 volts
— Maintien de la source 17 à une température proche de l'ambiante par une circulation d'eau,
— Polarisation du substrat comprise entre              — 100 volts et 0 volt
— Température du substrat maintenue entre       100 et 900 °C par chauffage électrique du porte-substrat

La polarisation de la source et du substrat peut être effectuée par courant continu ou alternatif.

## Revendications

1. Procédé pour le dépôt sur un substrat, conducteur ou non, d'une couche mince d'au moins un matériau à partir d'un plasma, du type consistant à disposer dans une enceinte, d'une part, au moins une source d'un matériau à déposer en couche mince sur un substrat et, d'autre part, ledit substrat, à réguler de façon indépendante la température de la source et du substrat, à prévoir des moyens de polarisation électrique de la source, à générer dans l'enceinte un plasma par des moyens propres d'excitation d'un milieu gazeux réactif par rapport au matériau de la source pour créer un produit de réaction volatil, à dissocier et ioniser partiellement ce dernier par le plasma et à déposer sur le substrat au moins un composé issu du produit de réaction volatil, caractérisé en ce que :

on confine le plasma dans l'enceinte par une enveloppe de confinement magnétique, disposée à l'intérieur de l'enceinte et constituée par une cage multipolaire,

on associe le substrat à des moyens propres de polarisation électrique,

et on ajuste, de façon indépendante, les polarisations électriques de la source et du substrat.

2. Procédé selon la revendication 1, caractérisé en ce que l'enveloppe de confinement magnétique est mise à la masse ou polarisée.

3. Procédé selon la revendication 1, caractérisé en ce que le milieu gazeux contient au moins un élément du dépôt à effectuer sur le substrat.

4. Procédé selon la revendication 1, caractérisé en ce qu'on dispose dans l'enceinte au moins deux sources de matériaux différents compatibles entre eux.

5. Procédé selon la revendication 1 ou 4, caractérisé en ce qu'on dispose dans l'enceinte n substrats devant être soumis à un dépôt.

6. Dispositif pour le dépôt sur un substrat d'une couche mince d'au moins un matériau à partir d'un plasma réactif par rapport audit matériau, du type comprenant une enceinte (1) associée à des moyens propres (13) de création du plasma, un support (16) d'une source (17), isolé électriquement de l'enceinte et associé à des moyens propres de polarisation électrique (18) et de régulation en température (19), un support (22) d'un substrat (23) isolé électriquement de l'enceinte et associé à des moyens de régulation en température (25), caractérisé en ce qu'il comprend :

une enveloppe (11) de confinement magnétique du plasma, disposée dans l'enceinte (1) et constituée par une cage multipolaire,

des moyens (24) de polarisation électrique propre du substrat,

et des moyens pour ajuster de façon indépendante les polarisations électriques du substrat et de la source.

7. Dispositif selon la revendication 6, caractérisé en ce que la cage multipolaire est associée à des moyens (12) de mise à la masse ou de polarisation.

8. Dispositif selon la revendication 6 ou 7, caractérisé en ce que l'enceinte comporte un système d'excitation du milieu gazeux qu'elle contient formé par un filament thermo-émissif (14) en matière réfractaire.

9. Dispositif selon la revendication 6 ou 7, caractérisé en ce que l'enceinte comporte un système d'excitation du milieu gazeux qu'elle contient formé par un générateur d'ondes hyperfréquences.

## Claims

1. Process for depositing on a substrate, conductive or not, a thin layer of at least one material from a plasma, of the type consisting in disposing in an enclosure, on the one hand, at least one source of a material to be deposited in thin layer on a substrate and, on the other hand, said substrate, in independently regulating the temperature of the source and of the substrate, in providing means for electrical biassing of the source, in generating in the enclosure a plasma by suitable means for excitation of a reactive gaseous medium with respect to the material of the source in order to create a volatile reaction product, in dissociating and ionizing the latter partially by the plasma and in depositing on the substrate at least one compound issuing from the volatile reaction product, characterized in that :

the plasma is contained in the enclosure by a magnetic containment envelope, disposed inside the enclosure and constituted by a multipole cage,

the substrate is associated with suitable means for electrical biassing,

and the electrical biassings of the source and of the substrate are adjusted independently.

2. Process according to Claim 1, characterized in that the magnetic containment envelope is connected to earth or biassed.

3. Process according to Claim 1, characterized in that the gaseous medium contains at least one element of the deposit to be effected on the substrate.

4. Process according to Claim 1, characterized in that at least two sources of different materials, compatible with each other, are disposed in the enclosure.

5. Process according to Claim 1 or 4, characterized in that n substrates having to be subjected to a deposit are disposed in the enclosure.

6. Device for depositing on a substrate a thin layer of at least one material from a reactive plasma with respect to said material, of the type comprising an enclosure (1) associated with suitable means (13) for creating the plasma, a support (16) of a source (17), electrically insulated from the enclosure and associated with suitable means for electrical biassing (18) and for regulation of temperature (19), a support (22) of a substrate (23) electrically insulated from the enclosure and associated with temperature regulating means (25), characterized in that it comprises :

a magnetic containment envelope (11) for the plasma, disposed in the enclosure (1) and constituted by a multipole cage,

means (24) for suitable electrical biassing of the substrate,

and means for independently adjusting the electrical biassings of the substrate and of the source.

7. Device according to Claim 6, characterized in that the multipole cage is associated with means (12) for connection to earth or for biassing.

8. Device according to Claim 6 or 7, characterized in that the enclosure comprises a system for excitation of the gaseous medium that it contains formed by a thermo-emissive filament (14) made of refractory material.

9. Device according to Claim 6 or 7, characterized in that the enclosure comprises a system for excitation of the gaseous medium that it contains formed by an ultra-high frequency wave generator.

## Patentansprüche

1. Verfahren zum Abscheiden einer Dünnschicht wenigstens eines Materials auf einem leitenden oder nichtleitenden Substrat aus einem Plasma, der Art, die daraus besteht, in einem Gehäuse einerseits wenigstens eine Quelle eines als Dünnschicht auf einem Substrat abzuscheidenden Materials und andererseits dieses Substrat anzuordnen, in unabhängiger Weise die Temperatur der Quelle und des Substrats zu regulieren, Mittel zur elektrischen Polarisation der Quelle vorzusehen, im Gehäuse ein Plasma durch geeignete Mittel zur Anregung eines gegenüber dem Material der Quelle reaktiven gasförmigen Mediums zu erzeugen, um ein flüchtiges Reaktionsprodukt zu schaffen, dieses letztere durch das Plasma zu dissoziieren und teilweise zu ionisieren und auf dem Substrat wenigstens eine aus dem flüchtigen Reaktionsprodukt stammende Verbindung abzuscheiden, dadurch gekennzeichnet,

daß man das Plasma im Gehäuse durch eine magnetische Einschlußhülle einschließt, die im Inneren des Gehäuses angeordnet und durch einen vielpoligen Käfig gebildet ist,

das Substrat mit geeigneten Mitteln zur elektrischen Polarisation verbindet und

in unabhängiger Weise die elektrischen Polarisationen der Quelle und des Substrats justiert.

2. Verfahren nach dem Anspruch 1, dadurch gekennzeichnet, daß die magnetische Einschlußhülle an die Masse gelegt oder polarisiert wird.

3. Verfahren nach dem Anspruch 1, dadurch gekennzeichnet, daß das gasförmige Medium wenigstens ein Element der auf dem Substrat vorzunehmenden Abscheidung enthält.

4. Verfahren nach dem Anspruch 1, dadurch gekennzeichnet, daß man im Gehäuse wenigstens zwei Quellen unterschiedlicher, untereinander kompatibler Materialien anordnet.

5. Verfahren nach dem Anspruch 1 oder 4, dadurch gekennzeichnet, daß man im Gehäuse n Substrate anordnet, die einer Abscheidung ausgesetzt werden müssen.

6. Vorrichtung zum Abscheiden einer Dünnschicht wenigstens eines Materials auf einem Substrat aus einem gegen- über diesem Material reaktiven Plasma, der Art, die ein mit geeigneten Mitteln (13) zur Schaffung des Plasmas verbundenes Gehäuse (1), einen Träger (16) einer Quelle (17), der vom Gehäuse elektrisch isoliert und mit geeigneten Mitteln zur elektrischen Polarisation (18) und zur Temperaturregulierung (19) verbunden ist, und einen Träger (22) eines Substrats (23) aufweist, der vom Gehäuse elektrisch isoliert und mit Temperaturregulierungsmitteln (25) verbunden ist, dadurch gekennzeichnet, daß sie aufweist :

eine Hülle (11) zum magnetischen Einschluß des Plasmas, die im Gehäuse (1) angeordnet und durch einen vielpoligen Käfig gebildet ist,

Mittel (24) zur geeigneten elektrischen Polarisation des Substrats und

Mittel zum Justieren der elektrischen Polarisationen des Substrats und der Quelle in unabhängiger Weise.

7. Vorrichtung nach dem Anspruch 6, dadurch gekennzeichnet, daß der vielpolige Käfig mit Mitteln (12) zum Legen an die Masse oder zur Polarisation verbunden ist.

8. Vorrichtung nach dem Anspruch 6 oder 7, dadurch gekennzeichnet, daß das Gehäuse ein System zum Anregen des gasförmigen Mediums, das es enthält, aufweist, das aus einem thermoemissiven Faden (14) aus feuerfestem Material gebildet ist.

9. Vorrichtung nach dem Anspruch 6 oder 7, dadurch gekennzeichnet, daß das Gehäuse ein System zum Anregen des gasförmigen Mediums, das es enthält, aufweist, das aus einem Ultrahochfrequenzwellengenerator gebildet ist.